# EUROPEAN PATENT APPLICATION

(11) **EP 4 654 778 A1**
(43) Date of publication of application: **26.11.2025**
(21) Application number: 24924233.0
(22) Date of filing: 18.11.2024
(51) Int. Cl.: H10D 8/01, H10D 8/25, H10D 62/10

(54) **ZENER DIODE AND PREPARATION METHOD THEREFOR, AND INTEGRATED SEMICONDUCTOR STRUCTURE**

(30) Priority: 07.08.2024 CN 202411078775
(71) Applicant: United Nova Technology - Xianfeng (Shaoxing) Corp., Shaoxing, Zhejiang 312000 (CN)
(72) Inventor: DONG, Dashun, Shaoxing, Zhejiang 312000 (CN); ZHAO, Liangliang, Shaoxing, Zhejiang 312000 (CN); SUN, Wei, Shaoxing, Zhejiang 312000 (CN); LI, Yong, Shaoxing, Zhejiang 312000 (CN); GU, Xueqiang, Shaoxing, Zhejiang 312000 (CN)
(74) Representative: Kraus & Lederer PartGmbB
(86) International application number: PCT/CN2024/132563
(87) International publication number: WO 2025/189806

(57) **Abstract**

Embodiments of this application relate to a Zener diode, a method for preparing a Zener diode, and a semiconductor integrated structure. A first conductivity-type body region is set to include a plurality of sub-body regions, and the sub-body regions are spaced away from each other in a first conductivity-type well region; in a direction perpendicular to a plane where a semiconductor material layer is located, a projection of a second conductivity-type doped region covers and exceeds projections of outer contours of the plurality of sub-body regions; and at a position where the projection of the second conductivity-type doped region exceeds the projections of the outer contours of the plurality of sub-body regions and a position spaced between the sub-body regions, the second conductivity-type doped region is connected to the first conductivity-type well region. In this way, an operating current of the Zener diode can be increased without increasing a reverse leakage current of the Zener diode, thereby optimizing performance of the Zener diode.

## Description

### TECHNICAL FIELD

This application relates to the field of semiconductor technologies, and in particular, to a Zener diode, a method for preparing a Zener diode, and a semiconductor integrated structure.

### BACKGROUND

A Zener diode (Zener Diode, ZD), also referred to as a Zener diode, is a diode that is made by using a reverse breakdown characteristic of a PN junction and that plays a role in voltage stabilization. A current of the diode may vary in a very large range and a voltage of the diode is basically unchanged. The Zener diode has a very high resistance until a critical reverse breakdown voltage. At a critical breakdown point, a reverse resistance suddenly decreases to a very small resistance value, and in this low-resistance region, the current increases and the voltage basically keeps constant. Because of this characteristic, the Zener diode may be used as a voltage regulator, a voltage reference element, an overvoltage protector, or the like.

For the Zener diode, main parameters include a Zener voltage UZ, a Zener current IZ, a Zener resistance rZ, and a reverse leakage current IR. The Zener voltage UZ is a breakdown voltage of the PN junction. The Zener current IZ is a value of a current passing through the Zener diode at the Zener voltage. The Zener resistance rZ is a ratio of a voltage change to a current change at both terminals of the Zener diode. The ratio changes with different operating current. Generally, a larger operating current indicates a smaller Zener resistance. The reverse leakage current IR is a current existing before the PN junction breaks down. For the Zener diode, usually, a larger operating current indicates a smaller Zener resistance, a smaller leakage current, and better performance.

Usually, voltage stabilizing performance of the Zener diode may be improved by improving the operating current of the Zener diode. Currently, a common method for increasing the operating current of the Zener diode is to increase area of the PN junction of the Zener diode. However, an increase in the area of the PN junction causes an increase in a leakage current of the Zener diode, which limits an increase in the operating current. Therefore, how to improve the operating current of the Zener diode without increasing a reverse leakage current of the Zener diode is a technical problem to optimize performance of the Zener diode all along.

### SUMMARY

In view of this, to resolve at least one problem in the background, embodiments of this application provide a Zener diode, a method for preparing a Zener diode, and a semiconductor integrated structure.

According to a first aspect, an embodiment of this application provides a Zener diode. The Zener diode includes:
a semiconductor material layer;
a first conductivity-type well region, located in the semiconductor material layer;
a second conductivity-type doped region, extending from a surface of the semiconductor material layer to the first conductivity-type well region; and
a first conductivity-type body region, located in the first conductivity-type well region, and connected to the second conductivity-type doped region, where
the first conductivity-type body region includes a plurality of sub-body regions, and the sub-body regions are spaced away from each other in the first conductivity-type well region; in a direction perpendicular to a plane where the semiconductor material layer is located, a projection of the second conductivity-type doped region covers and exceeds projections of outer contours of the plurality of sub-body regions; and at a position where the projection of the second conductivity-type doped region exceeds the projections of the outer contours of the plurality of sub-body regions and a position spaced between the sub-body regions, the second conductivity-type doped region is connected to the first conductivity-type well region.

With reference to the first aspect of this application, in an optional implementation, the plurality of sub-body regions are arranged in an array, and adjacent sub-body regions are equally spaced.

With reference to the first aspect of this application, in an optional implementation, in the direction perpendicular to the plane where the semiconductor material layer is located, a shape of the projection of the second conductivity-type doped region is the same as shapes of projections of the outer contours of the plurality of sub-body regions.

With reference to the first aspect of this application, in an optional implementation, the Zener diode further includes: a plurality of first conductive contact structures in conductive connection to the second conductivity-type doped region, where
in the direction perpendicular to the plane where the semiconductor material layer is located, centers of projections of outer contours of the plurality of first conductive contact structures overlap with centers of the projections of the outer contours of the plurality of sub-body regions.

With reference to the first aspect of this application, in an optional implementation, in the direction perpendicular to the plane where the semiconductor material layer is located, the projection of each first conductive contact structure at least partially overlaps with the projection of each sub-body region.

According to a second aspect, an embodiment of this application provides a method for preparing a Zener diode. The method includes:
providing a semiconductor material layer;
forming a first conductivity-type well region in the semiconductor material layer;
forming a first conductivity-type body region in the first conductivity-type well region, where the first conductivity-type body region includes a plurality of sub-body regions spaced away from each other; and
forming a second conductivity-type doped region on the first conductivity-type well region and the first conductivity-type body region, where in a direction perpendicular to a plane where the semiconductor material layer is located, a projection of the second conductivity-type doped region covers and exceeds projections of outer contours of the plurality of sub-body regions; and at a position where the projection of the second conductivity-type doped region exceeds the projections of the outer contours of the plurality of sub-body regions and a position spaced between the sub-body regions, the second conductivity-type doped region is connected to the first conductivity-type well region.

With reference to the second aspect of this application, in an optional implementation, the plurality of sub-body regions are arranged in an array, and adjacent sub-body regions are equally spaced.

With reference to the second aspect of this application, in an optional implementation, in the direction perpendicular to the plane where the semiconductor material layer is located, a shape of a projection of the second conductivity-type doped region is the same as shapes of projections of the outer contours of the plurality of sub-body regions.

With reference to the second aspect of this application, in an optional implementation, the method further includes:
forming a plurality of first conductive contact structures in conductive connection to the second conductivity-type doped region on the semiconductor material layer, where
in the direction perpendicular to the plane where the semiconductor material layer is located, centers of projections of outer contours of the plurality of first conductive contact structures overlap with centers of the projections of the outer contours of the plurality of sub-body regions.

With reference to the second aspect of this application, in an optional implementation, in the direction perpendicular to the plane where the semiconductor material layer is located, the projection of each first conductive contact structure at least partially overlaps with the projection of each sub-body region.

According to a third aspect, an embodiment of this application provides a semiconductor integrated structure, including the Zener diode according to any one of the foregoing first aspect, or including a Zener diode prepared by using the method for preparing a Zener diode according to any one of the foregoing second aspect.

According to the Zener diode, the method for preparing a Zener diode, and the semiconductor integrated structure provided in the embodiments of this application, a first conductivity-type body region is set to include a plurality of sub-body regions, and the sub-body regions are spaced away from each other in a first conductivity-type well region; in a direction perpendicular to a plane where a semiconductor material layer is located, a projection of a second conductivity-type doped region covers and exceeds projections of outer contours of the plurality of sub-body regions; and at a position where the projection of the second conductivity-type doped region exceeds the projections of the outer contours of the plurality of sub-body regions and a position spaced between the sub-body regions, the second conductivity-type doped region is connected to the first conductivity-type well region. In this way, in a case of complying with a Design Rule, area of a PN junction is increased, and an increase in a proportion of area of the first conductivity-type body region to the area of the PN junction is avoided as much as possible, thereby avoiding a problem that an increase in a leakage current of the Zener diode is caused when the area of the PN junction is increased, achieving an increase in an operating current of the Zener diode without increasing a reverse leakage current of the Zener diode, and optimizing performance of the Zener diode.

Additional aspects and advantages of this application will be partially given in the following description, and some will become apparent from the following description, or will be understood by practice of this application.

### BRIEF DESCRIPTION OF THE DRAWINGS

Accompanying drawings described herein are used to provide a further understanding of this application, and constitute a part of this application. Exemplary embodiments of this application and descriptions thereof are used to explain this application, and do not constitute any inappropriate limitation to this application. In the accompanying drawings:
FIG. 1 is a schematic diagram of a cross-sectional structure of a Zener diode in a related technology;
FIG. 2 is a schematic diagram of a cross-sectional structure of a Zener diode in a comparative example;
FIG. 3 is a schematic diagram of a partial plane layout of the Zener diode shown in FIG. 2;
FIG. 4 is a schematic diagram of a cross-sectional structure of a Zener diode according to an embodiment of this application;
FIG. 5 is a schematic diagram of a partial plane layout of the Zener diode shown in FIG. 4;
FIG. 6 is a schematic flowchart of a method for preparing a Zener diode according to an embodiment of this application;
FIG. 7 is a schematic diagram of a cross-sectional structure of a Zener diode after a buried layer is formed in a process of preparing the Zener diode according to an embodiment of this application;
FIG. 8 is a schematic diagram of a cross-sectional structure of a Zener diode after a first epitaxial layer is formed in a process of preparing the Zener diode according to an embodiment of this application;
FIG. 9 is a schematic diagram of a cross-sectional structure of a Zener diode after a deep well is formed in a process of preparing the Zener diode according to an embodiment of this application;
FIG. 10 is a schematic diagram of a cross-sectional structure of a Zener diode after a second epitaxial layer is formed in a process of preparing the Zener diode according to an embodiment of this application;
FIG. 11 is a schematic diagram of a cross-sectional structure of a Zener diode after an isolation structure is formed in a process of preparing the Zener diode according to an embodiment of this application;
FIG. 12 is a schematic diagram of a cross-sectional structure of a Zener diode after a drift region is formed in a process of preparing the Zener diode according to an embodiment of this application;
FIG. 13 is a schematic diagram of a cross-sectional structure of a Zener diode after a first conductivity-type well region is formed in a process of preparing the Zener diode according to an embodiment of this application;
FIG. 14 is a schematic diagram of a cross-sectional structure of a Zener diode after a second conductivity-type well region is formed in a process of preparing the Zener diode according to an embodiment of this application;
FIG. 15 is a schematic diagram of a cross-sectional structure of a Zener diode after a first conductivity-type body region is formed in a process of preparing the Zener diode according to an embodiment of this application;
FIG. 16 is a schematic diagram of a cross-sectional structure of a Zener diode after a second conductivity-type doped region is formed in a process of preparing the Zener diode according to an embodiment of this application;
FIG. 17 is a schematic diagram of a cross-sectional structure of a Zener diode after a first conductive lead-out region is formed in a process of preparing the Zener diode according to an embodiment of this application;
FIG. 18 is a schematic diagram of a cross-sectional structure of a Zener diode after a patterned eighth mask layer is removed in a process of preparing the Zener diode according to an embodiment of this application;
FIG. 19 is a simulated structural diagram of a Zener diode in a related technology;
FIG. 20 is a simulated electric potential line diagram of the Zener diode shown in FIG. 19;
FIG. 21 is a simulated structural diagram of a Zener diode according to a specific example of this application;
FIG. 22 is a simulated electric potential line diagram of the Zener diode shown in FIG. 21; and
FIG. 23 is a comparative diagram of reverse breakdown curves of the Zener diode shown in FIG. 19 and the Zener diode shown in FIG. 21.

Reference signs in the accompanying drawings:
100, semiconductor material layer; 101, growth substrate; 102, first epitaxial layer; 103, second epitaxial layer; 110, buried layer; 120, deep well; 130, isolation structure; 140, drift region; 151, first conductivity-type well region; 152, third well region; 160, second conductivity-type well region; 170, first conductivity-type body region; 1701, sub-body region; 181, second conductivity-type doped region; 182, second conductive lead-out region; 191, first conductive lead-out region; 192, third conductive lead-out region; 210, first mask layer; 220, second mask layer; 230, third mask layer; 240, fourth mask layer; 250, fifth mask layer; 260, sixth mask layer; 270, seventh mask layer; 280, eighth mask layer; 310, first conductive contact structure; 320, second conductive contact structure; 330, third conductive contact structure; and 340, fourth conductive contact structure.

### DETAILED DESCRIPTION

Exemplary implementations of this application will be described in more detail with reference to accompanying drawings. Although exemplary implementations of this application are shown in the accompanying drawings, it is to be understood that this application may be implemented in various forms and are not be limited to specific implementations described herein. On the contrary, these implementations are provided to better understand this application, and to completely convey a scope of this application to a person skilled in the art.

In the following description, a large number of specific details are provided to provide a more complete understanding of this application. However, a person skilled in the art easily understands that this application may be implemented without one or more of these details. In other examples, to avoid confusion with this application, some technical features well-known in the art are not described. That is, not all features of actual embodiments are described herein, and well-known functions and structures are not described in detail.

In the accompanying drawings, sizes of layers, regions, and elements and relative sizes of the layers, regions, and elements may be exaggerated for clarity. Throughout the accompanying drawings, the same reference signs represent the same elements.

It is to be understood that when an element or layer is referred to as being "on", "adjacent to", "connected to", or "coupled to" another element or layer, the element or layer may be directly on, adjacent to, connected to, or coupled to the another element or layer, or there may be an intermediate element or layer. On the contrary, when the element is referred to as being "directly on", "directly adjacent to", or "directly connected to", or "directly coupled to" another element or layer, there is no intermediate element or layer. It is to be understood that although terms such as "first", "second", and "third" may be used to describe various elements, components, regions, layers, and/or parts, these elements, components, regions, layers, and/or parts are not limited by these terms. These terms are only used to distinguish one element, component, region, layer, or part from another element, component, region, layer, or part. Therefore, without departing from the teaching of this application, a first element, component, region, layer, or part discussed below may be represented as a second element, component, region, layer, or part. When a second element, component, region, layer, or part is discussed, it does not indicate that the first element, component, region, layer, or part necessarily exists in this application.

Spatial relational terms such as "under", "below", "lower", "beneath", "above", and "upper" may be used herein for ease of description to describe a relationship between one element or feature shown in the figure and another element or feature. It is to be understood that in addition to orientations shown in the figures, the spatial relational terms are intended to further include different orientations of a device during use and operation. For example, if a device in an accompanying drawing is reversed, an element or feature described as being "below" or "under" or "beneath" another element is oriented as being "above" another element or feature. Therefore, exemplary terms "below" and "under" may include two orientations of above and below. The device may be otherwise oriented (rotated by 90 degrees or at another orientation) and a spatial description used herein is correspondingly explained.

Terms used herein are merely intended to describe specific embodiments and are not intended to limit this application. When used herein, singular forms "a", "an", and "the" are alternatively intended to include plural forms, unless context clearly indicates otherwise. It is to be further understood that terms "include" and/or "comprise", when used in this specification, specify presence of described features, integers, steps, operations, elements, and/or components, but do not exclude the presence or addition of one or more other features, integers, steps, operations, elements, components, and/or combinations thereof. When used herein, the term "and/or" includes any or all combinations of one or more related listed items.

To thoroughly understand this application, detailed steps and detailed structures are provided in the following description, so as to explain the technical solutions of this application. Preferred embodiments of this application are described in detail below. However, in addition to these detailed descriptions, this application may further have other implementations.

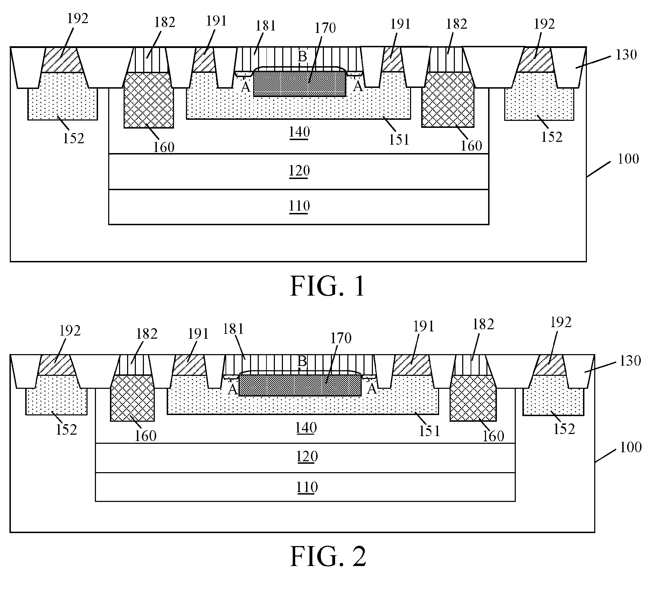

FIG. 1 is a schematic diagram of a cross-sectional structure of a Zener diode in a related technology. As shown in FIG. 1, the Zener diode includes a semiconductor material layer 100, a first conductivity-type well region 151 is formed in the semiconductor material layer 100, and a first conductivity-type body region 170 and a second conductivity-type doped region 181 are formed in the first conductivity-type well region 151. The second conductivity-type doped region 181 is formed on a surface layer of the semiconductor material layer 100. The first conductivity-type body region 170 is connected to the second conductivity-type doped region 181 and is located below the second conductivity-type doped region 181. A first conductivity type is, for example, a P-type, so that the first conductivity-type well region 151 is specifically a PW region (Pwell), and the first conductivity-type body region 170 is specifically a PB region (Pbody). A second conductivity type is, for example, an N-type, so that the second conductivity-type doped region 181 is an N-type doped region, and is specifically a heavily-doped N+ doped region (an SN region).

In a region A in FIG. 1, the second conductivity-type doped region 181 is connected to the first conductivity-type well region 151. Because an ion doping concentration of the first conductivity-type well region 151 is relatively low, avalanche breakdown occurs on a PN junction (a PW/SN junction) formed between the second conductivity-type doped region 181 and the first conductivity-type well region 151 by impact ionization, and a breakdown voltage BV of the PN junction (the PW/SN junction) is about 10 V, and a leakage current is relatively small. In a region B in FIG. 1, the second conductivity-type doped region 181 is connected to the first conductivity-type body region 170. Because ion doping concentrations of both the second conductivity-type doped region 181 and the first conductivity-type body region 170 are relatively high, Zener breakdown occurs on a PN junction (a PB/SN junction) formed between the second conductivity-type doped region 181 and the first conductivity-type body region 170 by tunneling, and a breakdown voltage BV of the PN junction (the PB/SN junction) is about 10 V, and a leakage current is relatively large.

For the Zener diode, when the breakdown voltage BV is 5.8 V, the Zener diode has a relatively small temperature drift coefficient. Therefore, particular proportions of the PW/SN junction and the PB/SN junction are required, that is, a particular proportion of the PW region is further included outside the PB region, so that a final BV approaches 5.8 V only after combination.

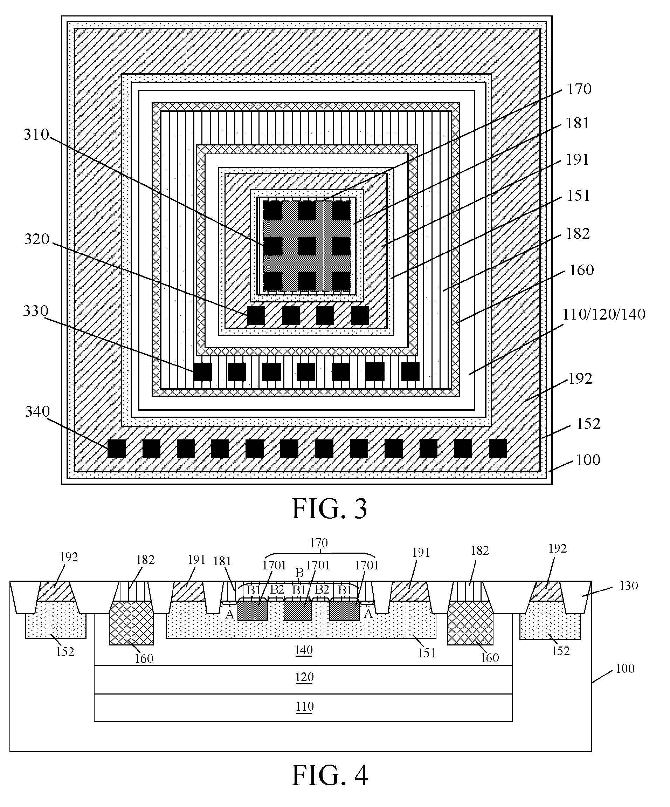

To improve voltage stabilizing performance of the Zener diode, an operating current of the Zener diode needs to be increased. A common method for increasing the operating current is to increase area of the PN junction of the Zener diode. In a case of complying with a Design Rule, a manner of increasing the area of the PN junction is shown in FIG. 2 and FIG. 3. This manner may cause an increase in a proportion of area of the PB region to the area of the entire PN junction. The increase in the proportion will expand a reverse leakage current per unit area of the Zener diode and reduce the breakdown voltage BV of the Zener diode, which is disadvantageous to improvement of performance of the Zener diode. It is to be noted that to clearly show structures, FIG. 2 and FIG. 3 only schematically show that the area of the PN junction is increased to some extent compared with that in FIG. 1. In an actual application, the area of the PN junction may be increased several times, and correspondingly, the foregoing problem may be more prominent. In addition, although the area of the PB region and the area of the PN junction may alternatively be proportionally increased, a width of the region A synchronously increases, an overcurrent capability of a device becomes poor, and an on-resistance increases.

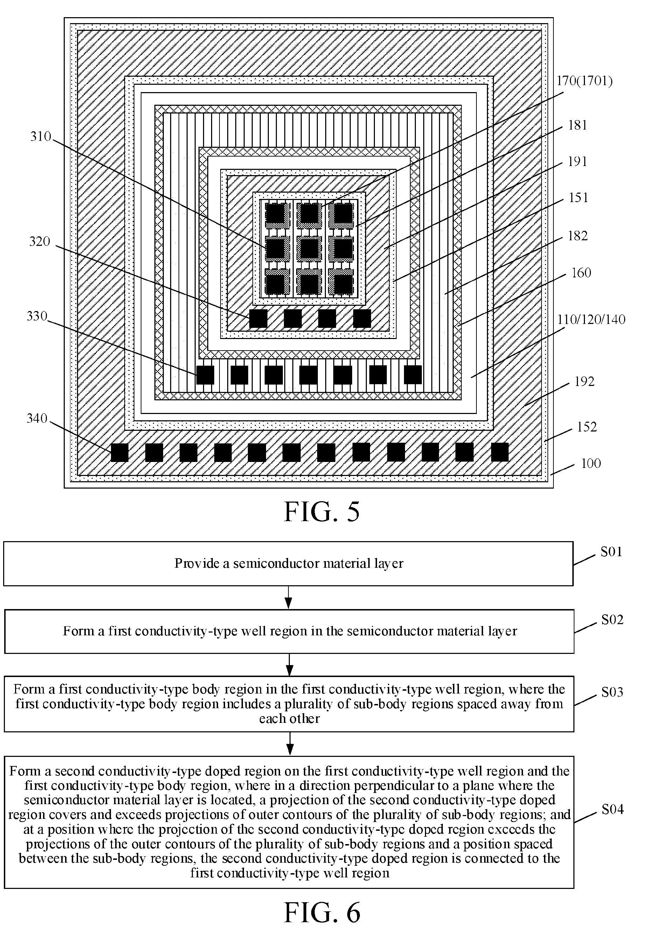

Based on this, an embodiment of this application provides a Zener diode. Referring to FIG. 4 and FIG. 5, the Zener diode includes: a semiconductor material layer 100; a first conductivity-type well region 151, located in the semiconductor material layer 100; a second conductivity-type doped region 181, extending from a surface of the semiconductor material layer 100 to the first conductivity-type well region 151; a first conductivity-type body region 170, located in the first conductivity-type well region 151, and connected to the second conductivity-type doped region 181, where the first conductivity-type body region 170 includes a plurality of sub-body regions 1701, and the sub-body regions 1701 are spaced away from each other in the first conductivity-type well region 151; in a direction perpendicular to a plane where the semiconductor material layer 100 is located, a projection of the second conductivity-type doped region 181 covers and exceeds projections of outer contours of the plurality of sub-body regions 1701; and at a position where the projection of the second conductivity-type doped region 181 exceeds the projections of the outer contours of the plurality of sub-body regions 1701 and a position spaced between the sub-body regions 1701, the second conductivity-type doped region 181 is connected to the first conductivity-type well region 151.

It may be understood that, the first conductivity-type body region 170 is set to include a plurality of sub-body regions 1701, there is spacing between the sub-body regions 1701, and a PN junction at a position (referring to B2 in FIG. 4) of the spacing is an interface connected between the second conductivity-type doped region 181 and the first conductivity-type well region 151, so that in a case of complying with a Design Rule, area of the PN junction is increased, and an increase in area of the first conductivity-type body region 170 relative to the area of the PN junction is avoided as much as possible, thereby avoiding a problem that an increase in a leakage current of the Zener diode is caused when the area of the PN junction is increased, achieving an increase in an operating current of the Zener diode without increasing a reverse leakage current of the Zener diode, and optimizing performance of the Zener diode.

The area of the first conductivity-type body region 170 is equal to a sum of area of the sub-body regions 1701 (referring to a sum of area of regions B1 in FIG. 4, or referring to a sum of area of dashed boxes in FIG. 5), and the area of the first conductivity-type body region 170 is area of an interface connected between the second conductivity-type doped region 181 and the first conductivity-type body region 170. The area of the PN junction is equal to a sum of the area of the interface connected between the second conductivity-type doped region 181 and the first conductivity-type body region 170 and the area of the interface connected between the second conductivity-type doped region 181 and the first conductivity-type well region 151 (referring to a sum of the area of a region A and the area of a region B in FIG. 4), that is, a sum of area at a position where the projection of the second conductivity-type doped region 181 exceeds the projections of the outer contours of the plurality of sub-body regions 1701, area at the position spaced between the sub-body regions 1701, and area of interfaces connected between the second conductivity-type doped region 181 and the sub-body regions 1701 (referring to a sum of the area of the region A, the area of the regions B1, and the area of the regions B2 in FIG. 4). In this embodiment, the area of the PN junction is alternatively equal to area of the second conductivity-type doped region 181. In this way, in this embodiment of this application, it can be ensured that the area of the region B (area in which the first conductivity-type body region 170 is distributed) is large enough to avoid an excessively large on-resistance when the area of the PN junction is extended. Different from a related technology, in this embodiment of this application, area of a PB region is no longer equal to the area of the region B, but is equal to the sum of the area of the regions B1. Therefore, a proportion of the sum of the area of the regions B1 to the area of the entire PN junction may not increase as the area of the PN junction increases.

Still referring to FIG. 4, in this embodiment of this application, a material of the semiconductor material layer 100 may include silicon (Si), germanium (Ge), silicon germanium (SiGe), and the like. In addition, this application alternatively does not exclude a case in which at least one III-V compound semiconductor material or II-VI compound semiconductor material, at least one organic semiconductor material, or another semiconductor material known in the art is included. The semiconductor material layer 100 may alternatively be another layer including a semiconductor material, for example, a Silicon-on-Insulator (SOI) substrate or a Germanium-on-Insulator (GeOI) substrate.

The semiconductor material layer 100 may be a one-layer structure including only a substrate, or may be a multi-layer structure including a growth substrate and at least one epitaxial layer. The "substrate" and the "growth substrate" refer to a carrier on which a subsequent material layer is formed, and the epitaxial layer is formed by epitaxial generation on the growth substrate.

The semiconductor material layer 100 may include an upper surface for forming a device structure and a lower surface opposite to the upper surface. In a case of ignoring flatness of the upper surface and the lower surface, a plane on which the upper surface and the lower surface of the semiconductor material layer 100 are located, or a center plane of the semiconductor material layer 100 in a strict sense, is determined as a plane where the semiconductor material layer is located. A direction parallel to the plane where the semiconductor material layer is located is a direction along the plane of the semiconductor material layer. A direction perpendicular to the plane where the semiconductor material layer is located may alternatively be referred to as a thickness direction or a height direction of the semiconductor material layer, and the direction is alternatively a direction in which material layers (for example, an epitaxial layer) are stacked, or referred to as a height direction of a device.

The semiconductor material layer 100 may have a first conductivity type. The first conductivity type is opposite to a second conductivity type. For example, the first conductivity type is a P-type, and the second conductivity type is an N-type; alternatively, the first conductivity type is an N-type, and the second conductivity type is a P-type.

The first conductivity-type well region 151 is located in the semiconductor material layer 100. In a specific example, an ion doping concentration of the first conductivity-type well region 151 ranges from 3E12 cm⁻³ to 3E13 cm⁻³. The first conductivity-type well region 151 is a lightly-doped region.

A conductivity type of the first conductivity-type body region 170 is the same as that of the first conductivity-type well region 151, but an ion doping concentration of the first conductivity-type body region 170 is greater than that of the first conductivity-type well region 151. In a specific example, an ion doping concentration of the first conductivity-type body region 170 ranges from 2E13 cm⁻³ to 8E14 cm⁻³. The first conductivity-type body region 170 may be further formed by performing ion injection in the first conductivity-type well region 151.

A depth of the first conductivity-type body region 170 may be less than a depth of the first conductivity-type well region 151, but is not limited thereto.

A conductivity type of the second conductivity-type doped region 181 is opposite to that of the first conductivity-type well region 151. Both the second conductivity-type doped region 181 and the first conductivity-type body region 170 are heavily-doped regions. In a specific example, an ion doping concentration of the second conductivity-type doped region 181 ranges from 6E13 cm⁻³ to 6E15 cm⁻³.

One part of the second conductivity-type doped region 181 is connected to the first conductivity-type well region 151. Because the ion doping concentration of the first conductivity-type well region 151 is relatively low, an avalanche diode is formed between the second conductivity-type doped region 181 and the first conductivity-type well region 151, and avalanche breakdown occurs by impact ionization. The other part of the second conductivity-type doped region 181 is connected to the first conductivity-type body region 170. Because ion doping concentrations of both the second conductivity-type doped region 181 and the first conductivity-type body region 170 are relatively high, a Zener diode is formed between the second conductivity-type doped region 181 and the first conductivity-type body region 170, and Zener breakdown occurs by tunneling. Because Zener breakdown occurs in a tunnel junction at a relatively low breakdown voltage and a relatively large leakage current, a proportion of area of the tunnel junction to the entire PN junction needs to be kept unchanged to prevent a Zener voltage UZ and a reverse leakage current IR per unit area of the device from increasing.

In this embodiment, the first conductivity type is, for example, a P-type, so that the first conductivity-type well region 151 is specifically a PW region, and the first conductivity-type body region 170 is specifically a PB region. The second conductivity type is, for example, an N-type, so that the second conductivity-type doped region 181 is an SN region.

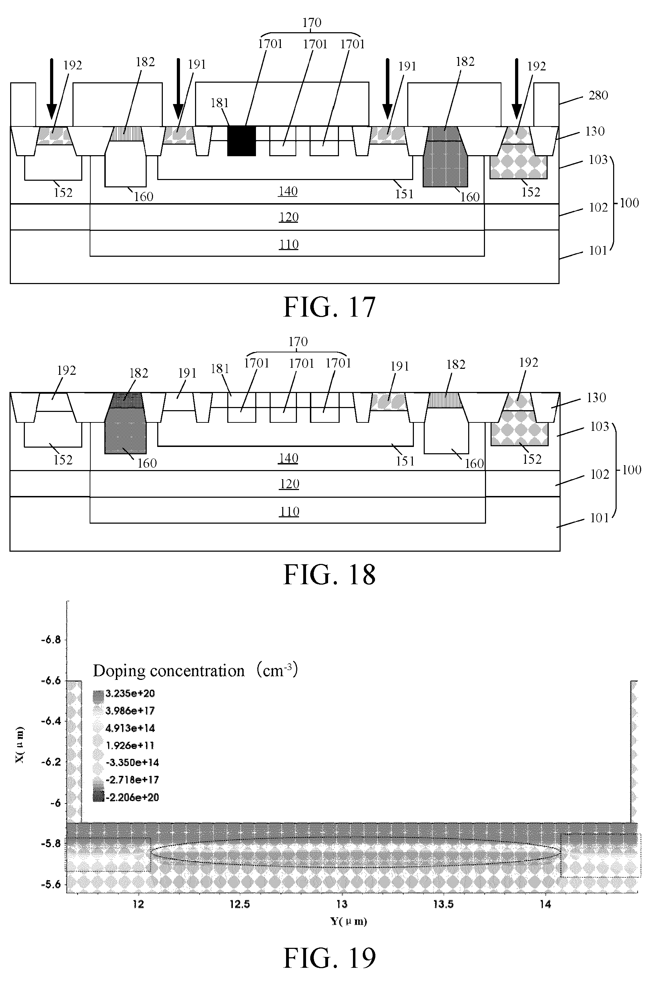

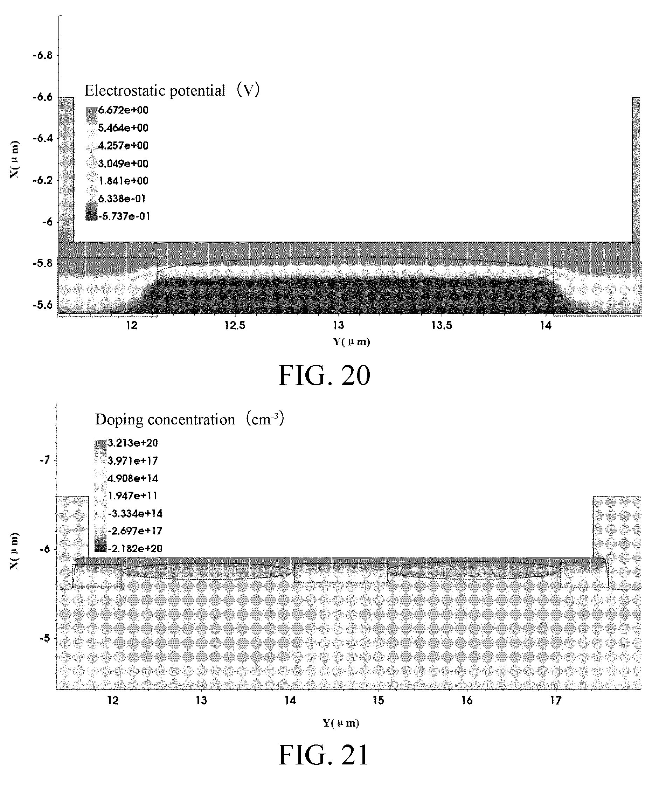

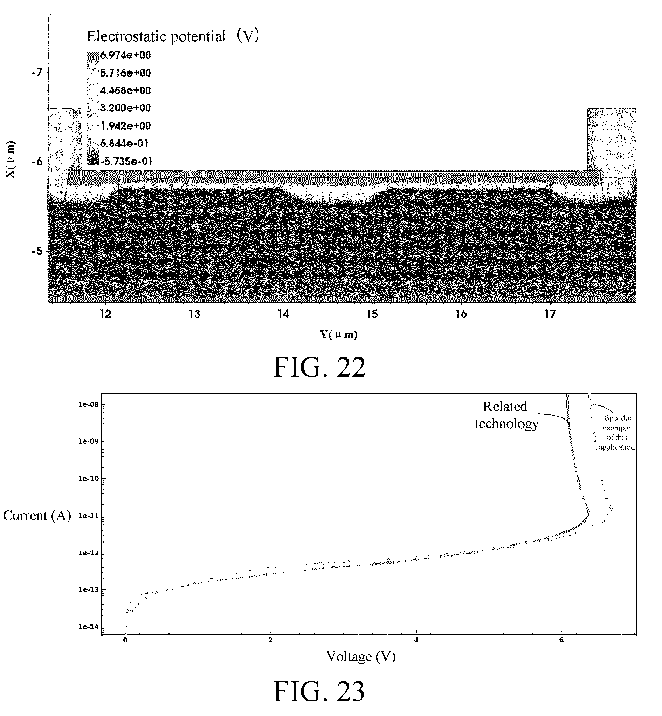

Refer to FIG. 19 to FIG. 23. FIG. 19 is a simulated structural diagram of a Zener diode in a related technology. Similar to the related technology shown in FIG. 1, a PB region of the Zener diode is of a single structure (Single Pbody). FIG. 21 is a simulated structural diagram of a Zener diode according to a specific example of this application. As shown in the figure, compared with FIG. 19, the Zener diode not only expands area of a PN junction, but also sets a PB region as a plurality of sub-body regions (Array Pbody) arranged in an array. Specifically, during simulation, the PB region is set as a 2*2 array sub-body region. Two sub-body regions can be seen in a cross section shown in FIG. 21. Electric potential lines of the Zener diode shown in FIG. 19 and the Zener diode shown in FIG. 21 are respectively shown in FIG. 20 and FIG. 22. It can be learned from the figure that equipotential lines at a PB/SN junction (shown by an elliptic dashed box) is more densely distributed than equipotential lines at a PW/SN junction (shown by a rectangular dashed box), that is, a spatial distance between the same potential difference is relatively small at the PB/SN junction. This indicates that electric field strength is relatively large at the PB/SN junction, and a leakage current at the PB/SN junction is worse than that at the PW/SN junction. Therefore, in a case of complying with the Design Rule, simply expanding area of the PN junction causes an increase in a proportion of area of the PB/SN junction, which certainly causes an increase in a leakage current per unit area. In addition, referring to FIG. 23, it can be learned from comparison of curves in the figure that, BV of the Zener diode having the Array Pbody shown in FIG. 21 is smaller than that of the Zener diode having the Single Pbody shown in FIG. 19. In a case of complying with the Design Rule, an Array Pbody structure is used, so that a fixed proportion of area of a PB/SN junction can still be maintained while expanding area of a PN junction, thereby improving an operating current of the Zener diode.

In an entire PN junction (including both the PB/SN junction and the PW/SN junction), a proportion of area of the PB/SN junction is about 0.3 to 0.4.

In an actual application, the area of the PN junction may be expanded several times, and a specific expansion multiple is determined according to a requirement on the operating current. For example, the area of the PN junction in a related technology is 2 µm*2 µm, while the area of the PN junction in this embodiment of this application is expanded to 4 µm*4 µm, 40 µm*40 µm, 60 µm*60 µm, or the like. It is to be understood that, although a calculation formula of area of a square is shown as an example, a shape of a projection of the PN junction on a substrate plane in this embodiment of this application is not limited thereto. As an optional specific implementation, the area of the PN junction is greater than or equal to 10 µm², and further optionally, for example, is 16 µm² to 3600 µm². While the area of the PN junction is expanded, the first conductivity-type body region 170 is set to include a plurality of sub-body regions 1701 spaced away from each other, so as to ensure that area of a region B large enough to avoid an excessively large on-resistance. More importantly, it can be ensured that a proportion of a sum of area of regions B1 to the area of the entire PN junction (that is, the proportion of the area the PB/SN junction) does not increase as the area of the PN junction increases, so that the operating current of the Zener diode can be controlled by using the area of the PN junction at the same time, and an increase of a leakage current of the Zener diode is avoided by properly setting the proportion of the area of the PB/SN junction, thereby obtaining the Zener diode with a more excellent voltage stabilizing effect.

Still referring to FIG. 5, a dashed box in the figure shows a position of each sub-body region 1701. Optionally, the plurality of sub-body regions 1701 may be arranged in an array.

FIG. 5 shows a case in which the plurality of sub-body regions 1701 are arranged in a matrix (specifically, a 3*3 square matrix). It is to be understood that the plurality of sub-body regions 1701 may be arranged in a square matrix, or may be arranged in a rectangular matrix. The array may be a 2*2 matrix, a 2*3 matrix, or a 3*3 matrix, or may be arranged as any other quantity of matrices according to actual requirements.

The plurality of sub-body regions 1701 are not limited to being arranged in a rectangular matrix. In some other embodiments, the plurality of sub-body regions 1701 may alternatively be arranged in a manner such as a circular array, an elliptic array, a linear array, or a polygonal array (for example, a pentagonal array, a hexagonal array, an octagonal array, ...).

Spacing between two adjacent sub-body regions 1701 is equal, so that a layout manner is simplified in a case of complying with a Design Rule, and overcurrent paths are distributed more evenly. Certainly, this application alternatively does not exclude that two adjacent sub-body regions 1701 are arranged at a non-equal spacing.

In this embodiment, a projection of each sub-body region 1701 in a direction perpendicular to a plane where the semiconductor material layer 100 is located is in a square shape. In some other embodiments, a shape of an orthographic projection of each sub-body region 1701 may alternatively be a rectangle, a circle, an ellipse, a polygon (for example, a pentagon, a hexagon, an octagon, ...), or the like.

The shape of the orthographic projection of each sub-body region 1701 may be the same as a shape of a subsequently formed conductive contact structure, so that a layout manner is simplified in a case of complying with a Design Rule, and overcurrent paths are distributed more evenly. Certainly, this application alternatively does not exclude a case in which the shape of the orthographic projection of each sub-body region 1701 is different from the shape of the conductive contact structure.

In a direction perpendicular to a plane where the semiconductor material layer 100 is located, a shape of a projection of the second conductivity-type doped region 181 is the same as shapes of projections of outer contours of the plurality of sub-body regions 1701. It may be understood that, the projections of the outer contours of the plurality of sub-body regions 1701 are a projection of a region B. A projection of the second conductivity-type doped region 181 is a projection of the PN junction. The shapes of the projections of the plurality of sub-body regions 1701 and the second conductivity-type doped region 181 are the same, which is more beneficial for the projection of the second conductivity-type doped region 181 to cover and exceed the projections of the outer contours of the plurality of sub-body regions 1701, is more beneficial for avoiding an uneven ring width of a region A at different positions, and avoids an excessively large on-resistance.

In this embodiment, both the shape of the projection of the second conductivity-type doped region 181 and the shapes of the projections of the outer contours of the plurality of sub-body regions 1701 are rectangular. In some other embodiments, the shapes of the projections of the outer contours of the plurality of sub-body regions 1701 and the projection of the second conductivity-type doped region 181 may alternatively be circles, ellipses, polygons (for example, pentagons, hexagons, octagons, ...), or the like.

Still referring to FIG. 4, in some embodiments of this application, the Zener diode may further include a drift region 140 located in the semiconductor material layer 100. The drift region 140 is located on an upper surface side of the semiconductor material layer 100. The drift region 140 has a second conductivity type. In this embodiment, the drift region 140 is an N-type drift region, and may be specifically a high-voltage N-type drift (HV-Ndrift, HNDR) region. The first conductivity-type well region 151 is located in the drift region 140, and is specifically located at a top of the drift region 140.

The Zener diode may further include a deep well 120 located in the semiconductor material layer 100, and the deep well 120 is located below the drift region 140. The deep well 120 has a second conductivity type. In this embodiment, the deep well 120 is a deep N-well (DNW).

The Zener diode may further include a buried layer 110 located in the semiconductor material layer 100, and the buried layer 110 is located below the deep well 120. The buried layer 110 has a second conductivity type. In this embodiment, the buried layer 110 is an N-type buried layer (NBL).

A second conductivity-type well region 160 may further be formed in the semiconductor material layer 100 on a side of the first conductivity-type well region 151. In this embodiment, the second conductivity-type well region 160 is specifically an NW (Nwell) region. Both the second conductivity-type well region 160 and the first conductivity-type well region 151 are located in the drift region 140. In some other embodiments, the Zener diode may alternatively not include the drift region 140, and both the second conductivity-type well region 160 and the first conductivity-type well region 151 are located in the deep well 120. In some other embodiments, the Zener diode may alternatively include neither the drift region 140 nor the deep well 120, and the second conductivity-type well region 160 and the first conductivity-type well region 151 are directly located in the semiconductor material layer 100. The second conductivity-type well region 160 may be separated from the first conductivity-type well region 151 by using an isolation structure 130.

A first conductive lead-out region 191 is further formed at a top of the first conductivity-type well region 151. A conductivity type of the first conductive lead-out region 191 is the same as that of the first conductivity-type well region 151, and an ion doping concentration of the first conductive lead-out region 191 is greater than that of the first conductivity-type well region 151. In this embodiment, the first conductive lead-out region 191 is a P+ lead-out region (an SP region).

The first conductive lead-out region 191 and the second conductivity-type doped region 181 are respectively located at different position at the top of the first conductivity-type well region 151. With reference to FIG. 4 and FIG. 5, the first conductive lead-out region 191 may be disposed around the second conductivity-type doped region 181. The first conductive lead-out region 191 may be separated from the second conductivity-type doped region 181 by using an isolation structure 130.

A second conductive lead-out region 182 is further formed at a top of the second conductivity-type well region 160. A conductivity type of the second conductive lead-out region 182 is the same as that of the second conductivity-type well region 160, and an ion doping concentration of the second conductive lead-out region 182 is greater than that of the second conductivity-type well region 160. In this embodiment, both the second conductive lead-out region 182 and the second conductivity-type doped region 181 are N+ lead-out regions (SN regions).

With reference to FIG. 4 and FIG. 5, the second conductive lead-out region 182 may be disposed around the first conductive lead-out region 191. The second conductive lead-out region 182 may be separated from the first conductive lead-out region 191 by using an isolation structure 130.

A third well region 152 may further be formed in the semiconductor material layer 100 on a side of the drift region 140. For ease of distinction, the first conductivity-type well region 151 may alternatively be referred to as a first well region. The second conductivity-type well region 160 may alternatively be referred to as a second well region. A conductivity type of the third well region 152 may be the same as that of the first well region, that is, the third well region 152 has a first conductivity type. In this embodiment, the third well region 152 is a PW region.

A third conductive lead-out region 192 is further formed at a top of the third well region 152. A conductivity type of the third conductive lead-out region 192 is the same as that of the third well region 152, and an ion doping concentration of the third conductive lead-out region 192 is greater than that of the third well region 152. In this embodiment, both the third conductive lead-out region 192 and the first conductive lead-out region 191 are P+ lead-out regions (SP regions).

With reference to FIG. 4 and FIG. 5, the third conductive lead-out region 192 may be disposed around the second conductive lead-out region 182. The third conductive lead-out 192 may be separated from the second conductive lead-out region 182 by using an isolation structure 130.

The isolation structure 130 extends from a surface of the semiconductor material layer 100 into the semiconductor material layer 100. The isolation structure 130 includes, but is not limited to, a Shallow Trench Isolation (STI) structure. The third conductive lead-out region 192 may alternatively be surrounded by the isolation structure 130.

In some embodiments, the Zener diode further includes: a plurality of first conductive contact structures 310 that are in conductive connection to the second conductivity-type doped region 181.

The first conductive contact structures 310 may be formed on a medium layer (not shown in the figure) above the semiconductor material layer 100, and is specifically located above the second conductivity-type doped region 181. In an actual application, the first conductive contact structure may be specifically a contact plug. It may be understood that, the second conductivity-type doped region 181, the first conductive lead-out region 191, the second conductive lead-out region 182, and the third conductive lead-out region 192 located on a surface layer of the semiconductor material layer 100 may all be led out by using the conductive contact structures. Referring to FIG. 5, the Zener diode may further include: a second conductive contact structure 320 that is in conductive connection to the first conductive lead-out region 191, a third conductive contact structure 330 that is in conductive connection to the second conductive lead-out region 182, and a fourth conductive contact structure 340 that is in conductive connection to the third conductive lead-out region 192.

In some embodiments, in the direction perpendicular to the plane where the semiconductor material layer 100 is located, centers of projections of outer contours of the plurality of first conductive contact structures 310 overlap with centers of the projections of the outer contours of the plurality of sub-body regions 1701. In this way, it is more beneficial to increasing a probability that the projections of the first conductive contact structures 310 overlap with the projections of the sub-body regions 1701, and enhancing an overcurrent capability of the device.

In some embodiments, in the direction perpendicular to the plane where the semiconductor material layer 100 is located, the projection of each first conductive contact structure 310 at least partially overlaps with the projection of each sub-body region 1701, thereby enhancing the overcurrent capability of the device.

It may be understood that, because an ion doping concentration of the first conductivity-type well region 151 is relatively low, if the first conductive contact structures 310 are distributed right above the region A or the region B2, there is almost no current in the first conductivity-type well region 151, and an on-resistance is relatively large. However, an ion doping concentration of the first conductivity-type body region 170 is relatively high, an overcurrent capability is relatively strong, and if the first conductive contact structures 310 are distributed right above the region B1, the on-resistance of the device is relatively small.

FIG. 5 shows a case in which the projection of each first conductive contact structure 310 completely falls within a range of the projection of each sub-body region 1701. However, in an actual process, it may be difficult to ensure that one or more first conductive contact structures 310 are completely disposed corresponding to the sub-body regions 1701, and an at least partial overlap between the projection of each first conductive contact structure 310 and the projection of each sub-body region 1701 can greatly enhance the overcurrent capability of the device. The spacing between the first conductive contact structures 310 is limited by a process condition. Therefore, in this embodiment of this application, the first conductivity-type body region 170 is set to include a plurality of sub-body regions 1701 spaced away from each other. Compared with a case in which the first conductivity-type body region 170 is set to a single structure and the area is equal to the sum of the area of the sub-body regions 1701 in this embodiment of this application, the area occupied by the region B is expanded, and the probability that the projection of each first conductive contact structure 310 overlaps with the projection of each sub-body region 1701 is increased.

In addition, even if the projection of one or some first conductive contact structures 310 does not overlap with or partially overlaps with the projection of any sub-body region 1701, a manner of including the plurality of sub-body regions 1701 spaced away from each other is more beneficial to increasing probability that the first conductive contact structure 310 approaches the sub-body region 1701. Specifically, if the first conductivity-type body region 170 is set to a single structure and the area is equal to the sum of the area of the sub-body regions 1701 in this embodiment of this application, that is, is equal to the sum of the area of all the regions B1, distribution of the first conductivity-type body region 170 in an entire PN junction region is contracted compared with that in this application, and the area of the region A is larger compared with that in this application. In this way, the probability that the first conductive contact structure 310 is located in the region A is increased, and is probably far away from a boundary of the first conductivity-type body region 170. Therefore, a quantity of the first conductive contact structures 310 from which a current can be effectively conducted is reduced, and consequently, an overcurrent capability is poor. However, in this embodiment of this application, if the projection of the first conductive contact structure 310 does not overlap with or partially overlaps with the projection of any sub-body region 1701, there is a high probability that the first conductive contact structure 310 is located near the sub-body region 1701, thereby ensuring an overcurrent capability of the device as much as possible.

The Zener diode provided in this embodiment of this application may be applied to an integrated structure made by using a Bipolar-CMOS-DMOS (BCD) process.

An embodiment of this application further provides a method for preparing a Zener diode. Referring to FIG. 6, the method includes the following steps:
Step S01: Provide a semiconductor material layer.
Step S02: Form a first conductivity-type well region in the semiconductor material layer.
Step S03: Form a first conductivity-type body region in the first conductivity-type well region, where the first conductivity-type body region includes a plurality of sub-body regions spaced away from each other.
Step S04: Form a second conductivity-type doped region on the first conductivity-type well region and the first conductivity-type body region, where in a direction perpendicular to a plane where the semiconductor material layer is located, a projection of the second conductivity-type doped region covers and exceeds projections of outer contours of the plurality of sub-body regions; and at a position where the projection of the second conductivity-type doped region exceeds the projections of the outer contours of the plurality of sub-body regions and a position spaced between the sub-body regions, the second conductivity-type doped region is connected to the first conductivity-type well region.

It may be understood that, according to the method, the first conductivity-type body region is set to include a plurality of sub-body regions spaced away from each other, and a PN junction at a position of spacing is an interface connected between the second conductivity-type doped region and the first conductivity-type well region, so that in a case of complying with a Design Rule, area of the PN junction is increased, and an increase in area of the first conductivity-type body region relative to the area of the PN junction is avoided as much as possible, thereby avoiding a problem that an increase in a leakage current of the Zener diode is caused when the area of the PN junction is increased, achieving an increase in an operating current of the Zener diode without increasing a reverse leakage current of the Zener diode, and optimizing performance of the Zener diode.

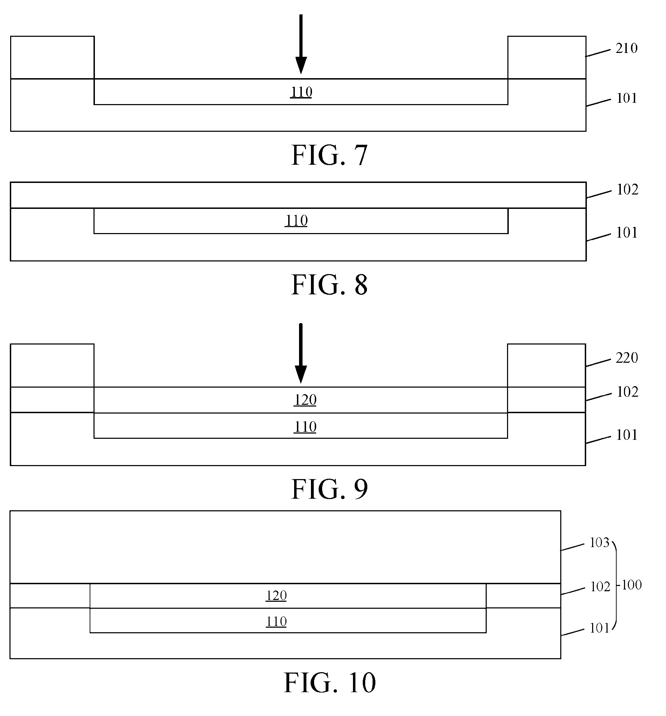

The method for preparing a Zener diode according to this embodiment of this application is further described in detail below with reference to FIG. 7 to FIG. 18.

First, referring to FIG. 7, a growth substrate 101 is provided. The growth substrate 101 may be a silicon substrate, a germanium substrate, a silicon germanium substrate, or the like. In addition, this application alternatively does not exclude a case in which a material of the growth substrate 101 includes at least one III-V compound semiconductor material or II-VI compound semiconductor material, at least one organic semiconductor material, or another semiconductor material known in the art.

A buried layer 110 is formed in the growth substrate 101. The buried layer 110 has a second conductivity type. In this embodiment, the buried layer 110 is an N-type buried layer (NBL). Forming the buried layer 110 may specifically include that a patterned first mask layer 210 is formed on the growth substrate 101, where the patterned first mask layer 210 exposes a preset formation region of the buried layer 110; and an ion injection process is performed by using the patterned first mask layer 210 as a mask, to form the buried layer 110 having the second conductivity type in the growth substrate 101.

Next, referring to FIG. 8, an epitaxial growth process is performed, to form a first epitaxial layer 102 on the growth substrate 101. In this embodiment, a material of the first epitaxial layer 102 is the same as a material of the growth substrate 101. Certainly, this application does not exclude a case in which the material of the first epitaxial layer 102 is different from the material of the growth substrate 101.

Next, referring to FIG. 9, a deep well 120 is formed in the first epitaxial layer 102. The deep well 120 has a second conductivity type. In this embodiment, the deep well 120 is a deep N-well (DNW). The deep well 120 is located above the buried layer 110, and is connected to the buried layer 110.

Forming the deep well 120 may specifically include that a patterned second mask layer 220 is formed on the first epitaxial layer 102, where the patterned second mask layer 220 exposes a preset formation region of the deep well 120; and an ion injection process is performed by using the patterned second mask layer 220 as a mask, to form the deep well 120 having the second conductivity type. It may be understood that, the deep well 120 is not limited to being located in the first epitaxial layer 102, and may alternatively extend into the growth substrate 101.

Next, referring to FIG. 10, an epitaxial growth process is performed, to form a second epitaxial layer 103 on the first epitaxial layer 102. In this embodiment, a material of the second epitaxial layer 103 is the same as a material of the growth substrate 101. Certainly, this application does not exclude a case in which the material of the second epitaxial layer 103 is different from the material of the growth substrate 101.

The growth substrate 101, the first epitaxial layer 102, and the second epitaxial layer 103 jointly form the semiconductor material layer 100.

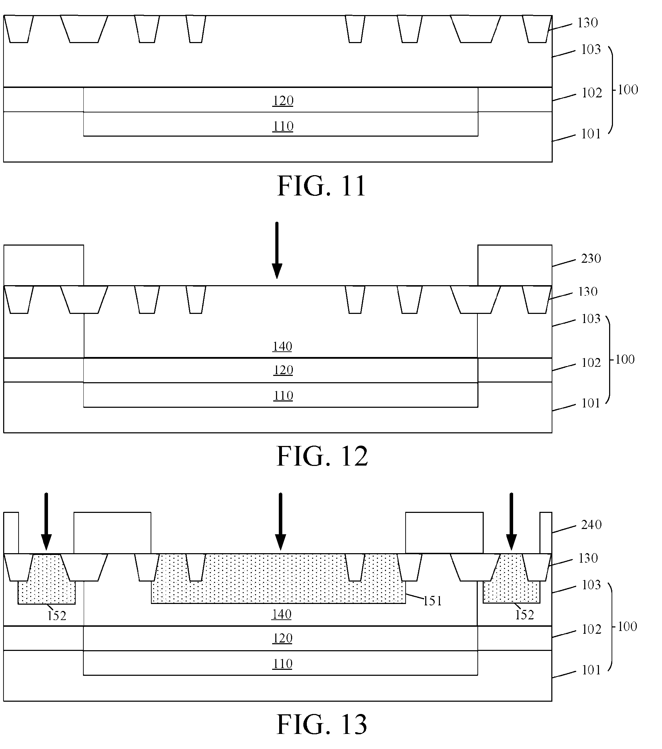

Next, referring to FIG. 11, an isolation structure 130 located in the semiconductor material layer 100 is formed on the second epitaxial layer 103. The isolation structure 130 includes, but is not limited to, a Shallow Trench Isolation structure. The isolation structure 130 defines an active region (an AA region) and doped regions of a device. The isolation structure 130 may include a plurality of annular portions that are nested inside and outside, and each annular portion is configured to distinguish a different doped region.

The isolation structure 130 may be formed by using a common process in the field, and is not described herein again.

Next, referring to FIG. 12, a drift region 140 is formed in the semiconductor material layer 100. The drift region 140 has a second conductivity type. In this embodiment, the drift region 140 is an N-type drift region, and may be specifically an HNDR region. The drift region 140 is located above the deep well 120, and is connected to the deep well 120.

Forming the drift region 140 may specifically include that a patterned third mask layer 230 is formed on the second epitaxial layer 103, where the patterned third mask layer 230 exposes a preset formation region of the drift region 140; and an ion injection process is performed by using the patterned third mask layer 230 as a mask, to form the drift region 140 having the second conductivity type. It may be understood that, the drift region 140 is not limited to being located in the second epitaxial layer 103, and may alternatively extend into the first epitaxial layer 102.

Next, referring to FIG. 13, a first conductivity-type well region 151 is formed in the semiconductor material layer 100. The first conductivity-type well region 151 is located in the drift region 140. In a specific example, an ion doping concentration of the first conductivity-type well region 151 ranges from 3E12 cm⁻³ to 3E13 cm⁻³. The first conductivity-type well region 151 is a lightly-doped region. In addition, the method may further include that a third well region 152 is formed in the semiconductor material layer 100, where the third well region 152 is located outside the drift region 140. The third well region 152 has a first conductivity type. In this embodiment, both the first conductivity-type well region 151 and the third well region 152 are PW regions.

In an actual process, the first conductivity-type well region 151 and the third well region 152 may be formed in the same step. Specifically, a patterned fourth mask layer 240 may be formed on the second epitaxial layer 103, where the patterned fourth mask layer 240 exposes preset formation regions of the first conductivity-type well region 151 and the third well region 152 (if the first conductivity-type well region 151 and the third well region 152 are formed in different processes, or only the first conductivity-type well region 151 is formed, a preset formation region where a well region is to be formed in the process is exposed); and an ion injection process is performed by using the patterned fourth mask layer 240 as a mask, to form the well region having the first conductivity type.

An ion doping concentration of the third well region 152 may alternatively range from 3E12 cm⁻³ to 3E13 cm⁻³.

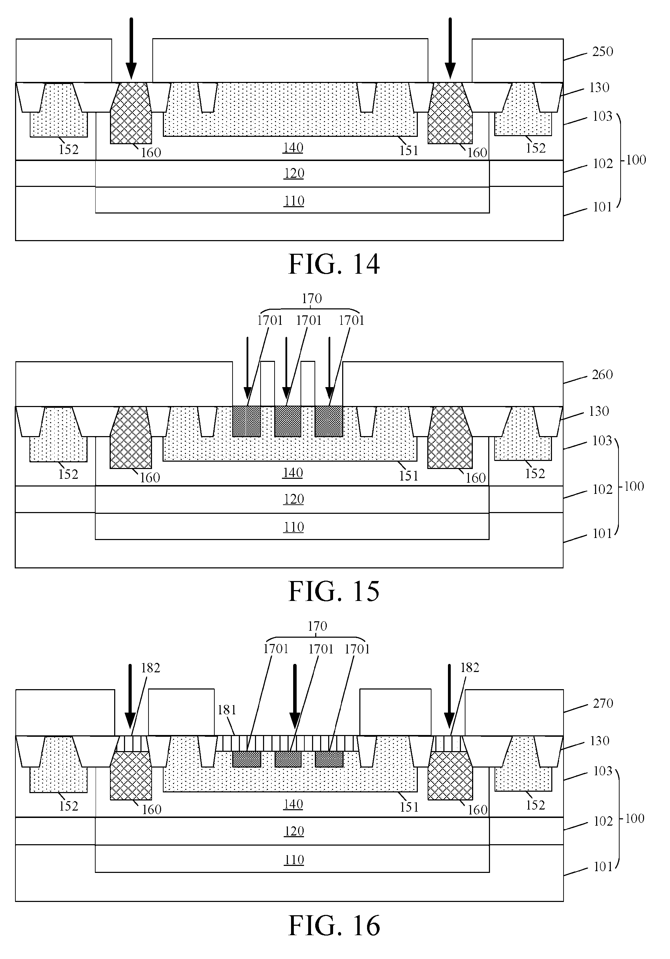

Next, referring to FIG. 14, a second conductivity-type well region 160 is formed. In this embodiment, the second conductivity-type well region 160 is specifically an NW region. Both the second conductivity-type well region 160 and the first conductivity-type well region 151 are located in the drift region 140.

Forming the second conductivity-type well region 160 may specifically include that a patterned fifth mask layer 250 is formed on the second epitaxial layer 103, where the patterned fifth mask layer 250 exposes a preset formation region of the second conductivity-type well region 160; and an ion injection process is performed by using the patterned fifth mask layer 250 as a mask, to form the second conductivity-type well region 160.

Next, referring to FIG. 15, a plurality of sub-body regions 1701 spaced away from each other are formed in the first conductivity-type well region 151, and the plurality of sub-body regions 1701 jointly form a first conductivity-type body region 170.

A conductivity type of each sub-body region 1701 is the same as that of the first conductivity-type well region 151, but an ion doping concentration of each sub-body region 1701 is greater than that of the first conductivity-type well region 151. In a specific example, an ion doping concentration of each sub-body region 1701 ranges from 2E13 cm⁻³ to 8E14 cm⁻³. The first conductivity-type body region 170 (each sub-body region 1701) may be specifically a PB region.

Forming the plurality of sub-body regions 1701 spaced away from each other may specifically include that a patterned sixth mask layer 260 is formed on the second epitaxial layer 103, where the patterned sixth mask layer 260 exposes a preset formation region of each sub-body region 1701; and an ion injection process is performed in the first conductivity-type well region 151 by using the patterned sixth mask layer 260 as a mask, to form the plurality of sub-body regions 1701.

In some other embodiments, forming the plurality of sub-body regions 1701 spaced away from each other may alternatively include that an entire body region having a contour the same as outer contours of the plurality of sub-body regions 1701 is formed first, then a material is removed from a spacing region between preset formation positions of the sub-body regions 1701, and the region from which the material is removed is filled with a material to form PW regions, so as to form the plurality of sub-body regions 1701 spaced away from each other. In addition, in some other embodiments, forming the plurality of sub-body regions 1701 spaced away from each other may alternatively include that an entire body region having a contour the same as outer contours of the plurality of sub-body regions 1701 is formed first, then ion injection is performed on a spacing region between preset formation positions of the sub-body regions 1701, and specifically, ions of an opposite type to that of doping ions of the sub-body regions 1701 are injected, to reduce an ion doping concentration of the spacing region to restore the spacing region to a PW region, and finally, to form the plurality of sub-body regions 1701 spaced away from each other.

A depth of each sub-body region 1701 may be less than a depth of the first conductivity-type well region 151, but is not limited thereto.

Optionally, the plurality of sub-body regions 1701 may be arranged in an array, and specifically, may be arranged in a matrix, for example, in a square matrix or a rectangular matrix. The array may be a 2*2 matrix, a 2*3 matrix, or a 3*3 matrix, or may be arranged as any other quantity of matrices according to actual requirements. In some other embodiments, the plurality of sub-body regions 1701 may alternatively be arranged in a manner such as a circular array, an elliptic array, a linear array, or a polygonal array (for example, a pentagonal array, a hexagonal array, an octagonal array, ...).

In some embodiments, spacing between two adjacent sub-body regions 1701 is equal, so that a layout manner is simplified in a case of complying with a Design Rule, and overcurrent paths are distributed more evenly.

Optionally, in a direction perpendicular to a plane where the semiconductor material layer 100 is located, shapes of projections of outer contours of the plurality of sub-body regions 1701 are the same as a shape of a projection of a subsequently formed second conductivity-type doped region 181. Therefore, it is more beneficial for the projection of the second conductivity-type doped region 181 to cover and exceed the projections of the outer contours of the plurality of sub-body regions 1701, is more beneficial for avoiding an uneven ring width of a region A at different positions, and avoids an excessively large on-resistance.

Next, referring to FIG. 16, a second conductivity-type doped region 181 is formed on a surface layer of the semiconductor material layer 100. The second conductivity-type doped region 181 is located on the first conductivity-type well region 151 and the first conductivity-type body region 170, a part of the second conductivity-type doped region 181 is connected to the first conductivity-type well region 151, and a part of the second conductivity-type doped region 181 is connected to the first conductivity-type body region 170.

A conductivity type of the second conductivity-type doped region 181 is opposite to that of the first conductivity-type well region 151. The second conductivity-type doped region 181 is a heavily-doped region. In a specific example, an ion doping concentration of the second conductivity-type doped region 181 ranges from 6E13 cm⁻³ to 6E15 cm⁻³.

In addition, the method may further include that a second conductive lead-out region 182 is formed in the semiconductor material layer 100. The second conductive lead-out region 182 is located at a top of the second conductivity-type well region 160, a conductivity type of the second conductive lead-out region 182 is the same as that of the second conductivity-type well region 160, and an ion doping concentration of the second conductive lead-out region 182 is greater than that of the second conductivity-type well region 160. In this embodiment, both the second conductive lead-out region 182 and the second conductivity-type doped region 181 are SN regions.

The second conductive lead-out region 182 and the second conductivity-type doped region 181 may be formed in the same process.

Forming the second conductivity-type doped region 181 and/or the second conductive lead-out region 182 may specifically include that a patterned seventh mask layer 270 is formed on the second epitaxial layer 103, where the patterned seventh mask layer 270 exposes a preset formation region of the second conductivity-type doped region 181 and/or the second conductive lead-out region 182 (where the preset formation region of the second conductivity-type doped region 181 exceeds preset formation regions of outer contours of the plurality of sub-body regions 1701); and an ion injection process is performed by using the patterned seventh mask layer 270 as a mask, to form the second conductivity-type doped region 181 and/or the second conductive lead-out region 182 on a surface layer of the second epitaxial layer 103. Specifically, the second conductivity-type doped region 181 is located at a top of the first conductivity-type well region 151, and the second conductive lead-out region 182 is located at a top of the second conductivity-type well region 160.

Next, referring to FIG. 17, a first conductive lead-out region 191 is formed on a surface layer of the semiconductor material layer 100. The first conductive lead-out region 191 is located at a position, different from a position where the second conductivity-type doped region 181 is located, at the top of the first conductivity-type well region 151. The first conductive lead-out region 191 is connected to the first conductivity-type well region 151, and is configured to lead out the first conductivity-type well region 151 conductively.

A conductivity type of the first conductive lead-out region 191 is the same as that of the first conductivity-type well region 151, and an ion doping concentration of the first conductive lead-out region 191 is greater than that of the first conductivity-type well region 151. In this embodiment, the first conductive lead-out region 191 is an SP region.

In addition, the method may further include that a third conductive lead-out region 192 is formed in the semiconductor material layer 100. The third conductive lead-out region 192 is formed at a top of the third well region 152. A conductivity type of the third conductive lead-out region 192 is the same as that of the third well region 152, and an ion doping concentration of the third conductive lead-out region 192 is greater than that of the third well region 152. In this embodiment, both the third conductive lead-out region 192 and the first conductive lead-out region 191 are SP regions.

The third conductive lead-out region 192 and the first conductive lead-out region 191 may be formed in the same process.

Forming the first conductive lead-out region 191 and/or the third conductive lead-out region 192 may specifically include that a patterned eighth mask layer 280 is formed on the second epitaxial layer 103, where the patterned eighth mask layer 280 exposes a preset formation region of the first conductive lead-out region 191 and/or the third conductive lead-out region 192; and an ion injection process is performed by using the patterned eighth mask layer 280 as a mask, to form the first conductive lead-out region 191 and/or the third conductive lead-out region 192 on a surface layer of the second epitaxial layer 103. Specifically, the first conductive lead-out region 191 is formed at a top of the first conductivity-type well region 151, and the third conductive lead-out region 192 is formed at a top of the third well region 152.

Next, referring to FIG. 18, the patterned eighth mask layer 280 is removed.

Next, the method may further include that a plurality of first conductive contact structures 310 that is in conductive connection to the second conductivity-type doped region 181 are formed on the semiconductor material layer 100 (referring to FIG. 5).

In addition, the method may further include that a second conductive contact structure 320 that is in conductive connection to the first conductive lead-out region 191, a third conductive contact structure 330 that is in conductive connection to the second conductive lead-out region 182, and a fourth conductive contact structure 340 that is in conductive connection to the third conductive lead-out region 192 are formed on the semiconductor material layer 100. In addition, the conductive contact structures may be formed in the same process, but are not limited thereto.

Forming each conductive contact structure may specifically include the following specific steps that a medium layer (not shown in the figure) is formed on the semiconductor material layer 100, several through holes are formed in the medium layer by photographing and etching processes, and the through holes are filled with a conductive material, to form several conductive contact structures.

In some embodiments, in the direction perpendicular to the plane where the semiconductor material layer 100 is located, centers of projections of outer contours of the plurality of first conductive contact structures 310 overlap with centers of the projections of the outer contours of the plurality of sub-body regions 1701. In this way, it is more beneficial to increasing a probability that the projections of the first conductive contact structures 310 overlap with the projections of the sub-body regions 1701, and enhancing an overcurrent capability of the device.

In some embodiments, in the direction perpendicular to the plane where the semiconductor material layer 100 is located, the projection of each first conductive contact structure 310 at least partially overlaps with the projection of each sub-body region 1701, thereby enhancing the overcurrent capability of the device.

Based on this, an embodiment of this application further provides a semiconductor integrated structure, including a Zener diode provided in any one of the foregoing embodiments of the Zener diode, or including a Zener diode prepared by using any one of the foregoing embodiments of the method for preparing a Zener diode.

It is to be noted that the embodiments of the method for preparing a Zener diode provided in this application and the foregoing embodiments of the Zener diode belong to the same concept. Technical features in the technical solutions described in the embodiments may be randomly combined with each other as long as there is no conflict.

It is to be understood that the foregoing embodiments are all exemplary, and are not intended to include all possible implementations. Various modifications and changes may further be made based on the foregoing embodiments without departing from a scope of the present disclosure. Similarly, technical features of the foregoing embodiments may alternatively be randomly combined to form another embodiment of this application that may not be explicitly described. Therefore, the foregoing embodiments express only several implementations of this application, and do not limit a scope of protection of this patent application.

## Claims

1. A Zener diode, comprising:
a semiconductor material layer;
a first conductivity-type well region, located in the semiconductor material layer;
a second conductivity-type doped region, extending from a surface of the semiconductor material layer to the first conductivity-type well region; and
a first conductivity-type body region, located in the first conductivity-type well region, and connected to the second conductivity-type doped region, wherein
the first conductivity-type body region comprises a plurality of sub-body regions, and the sub-body regions are spaced away from each other in the first conductivity-type well region; in a direction perpendicular to a plane where the semiconductor material layer is located, a projection of the second conductivity-type doped region covers and exceeds projections of outer contours of the plurality of sub-body regions; and at a position where the projection of the second conductivity-type doped region exceeds the projections of the outer contours of the plurality of sub-body regions and a position spaced between the sub-body regions, the second conductivity-type doped region is connected to the first conductivity-type well region.

2. The Zener diode according to claim 1, wherein the plurality of sub-body regions are arranged in an array, and adjacent sub-body regions are equally spaced.

3. The Zener diode according to claim 1, wherein in the direction perpendicular to the plane where the semiconductor material layer is located, a shape of a projection of the second conductivity-type doped region is the same as shapes of projections of the outer contours of the plurality of sub-body regions.

4. The Zener diode according to claim 1, further comprising: a plurality of first conductive contact structures in conductive connection to the second conductivity-type doped region, wherein
in the direction perpendicular to the plane where the semiconductor material layer is located, centers of projections of outer contours of the plurality of first conductive contact structures overlap with centers of the projections of the outer contours of the plurality of sub-body regions.

5. The Zener diode according to claim 4, wherein in the direction perpendicular to the plane where the semiconductor material layer is located, the projection of each first conductive contact structure at least partially overlaps with the projection of each sub-body region.

6. A method for preparing a Zener diode, comprising:
providing a semiconductor material layer;
forming a first conductivity-type well region in the semiconductor material layer;
forming a first conductivity-type body region in the first conductivity-type well region, wherein the first conductivity-type body region comprises a plurality of sub-body regions spaced away from each other; and
forming a second conductivity-type doped region on the first conductivity-type well region and the first conductivity-type body region, wherein in a direction perpendicular to a plane where the semiconductor material layer is located, a projection of the second conductivity-type doped region covers and exceeds projections of outer contours of the plurality of sub-body regions; and at a position where the projection of the second conductivity-type doped region exceeds the projections of the outer contours of the plurality of sub-body regions and a position spaced between the sub-body regions, the second conductivity-type doped region is connected to the first conductivity-type well region.

7. The method for preparing a Zener diode according to claim 6, wherein the plurality of sub-body regions is arranged in an array, and adjacent sub-body regions are equally spaced.

8. The method for preparing a Zener diode according to claim 6, wherein, in the direction perpendicular to the plane where the semiconductor material layer is located, a shape of a projection of the second conductivity-type doped region is the same as shapes of projections of the outer contours of the plurality of sub-body regions.

9. The method for preparing a Zener diode according to claim 6, further comprising:
forming a plurality of first conductive contact structures in conductive connection to the second conductivity-type doped region on the semiconductor material layer, wherein
in the direction perpendicular to the plane where the semiconductor material layer is located, centers of projections of outer contours of the plurality of first conductive contact structures overlap with centers of the projections of the outer contours of the plurality of sub-body regions.

10. The method for preparing a Zener diode according to claim 9, wherein in the direction perpendicular to the plane where the semiconductor material layer is located, the projection of each first conductive contact structure at least partially overlaps with the projection of each sub-body region.

11. A semiconductor integrated structure, comprising the Zener diode according to any one of claims 1 to 5, or comprising a Zener diode prepared by using the method for preparing a Zener diode according to any one of claims 6 to 10.
